# EUROPÄISCHE PATENTSCHRIFT

(11) **EP 1 352 430 B1**
(45) Veröffentlichungstag und Bekanntmachung des Hinweises auf die Patenterteilung: **10.09.2008**
(21) Anmeldenummer: 01984718.5
(22) Anmeldetag: 14.12.2001
(51) Int. Cl.: H01L 21/8242, H01L 21/8247, H01L 27/108, H01L 27/115, H01L 27/06

(54) **Herstellungsverfahren für einen DRAM- oder FeRAM-Speicher mit zwei Kondensatoren pro Auswahltransistor**
Method for producing a DRAM or FeRAM memory with two capacitors per access transistor
Procédé de fabrication d'une mémoire de type DRAM ou FeRAM ayant deux condensateurs par transistor de sélection

(30) Priorität: 29.12.2000 DE 10065669
(43) Veröffentlichungstag der Anmeldung: 15.10.2003
(73) Patentinhaber: Qimonda AG, 81739 München (DE)
(72) Erfinder: KASTNER, Marcus, Beitou, 112 Tapei R.O.C (TW); MIKOLAJICK, Thomas, 81543 München (DE)
(74) Vertreter: Kottmann, Heinz Dieter
(86) Internationale Anmeldenummer: PCT/DE2001/004767
(87) Internationale Veröffentlichungsnummer: WO 2002/054494

(56) Entgegenhaltungen:
- US-A- 4 959 709
- US-A- 5 684 316
- PATENT ABSTRACTS OF JAPAN vol. 017, no. 702 (E-1482), 21. Dezember 1993 (1993-12-21) & JP 05 243521 A (FUJITSU LTD), 21. September 1993 (1993-09-21) in der Anmeldung erwähnt

## Beschreibung

Die Erfindung betrifft ein Verfahren zur Herstellung einer integrierten Halbleiterspeicheranordnung gemäß dem Oberbegriff des Patentanspruches 1. Ein derartiges Verfahren ist aus JP 05243521 A nebst zugehörigem Abstract bekannt.

Für die Funktionalität sowie die Zuverlässigkeit ferroelektrischer Speicher (FeRAMs) und DRAMs mit hoher Dielektrizitätskonstante ε ist die Größe der umschaltbaren Polarisation bzw. die auf den Kondensatorplatten speicherbare Ladung von entscheidender Bedeutung. Die durch diese Polarisation oder Ladung beim Lesen verursachte Spannung auf der Bitleitung (BL) darf einen für das Produkt spezifizierten Minimalwert nicht unterschreiten. Im einfachsten Fall ist eine Erhöhung des BL-Signals durch eine Vergrößerung der Kondensatorfläche zu erreichen, was jedoch mit einer Erhöhung der Chipfläche einhergeht.

Es wurde bereits versucht, das BL-Signal durch eine Verringerung der Dicke sowie Designoptimierungen (niedrige Bitleitungskapazität) sowie durch eine geeignete Wahl des Ferro-oder Dielektrikums (hohe Dielektrizitätskonstante ε) zu erhöhen. Diesen Wegen sind allerdings technologische Grenzen gesetzt, da diese Maßnahmen meist eine Vergrößerung der Kondensatorfläche zu Lasten der Packungsdichte mit sich bringen.

In bekannten Speicherzellen wird üblicherweise nur ein Speicherkondensator pro Auswahltransistor angesprochen. Somit lässt sich auch für jede Adresse nur ein Bit Information speichern.

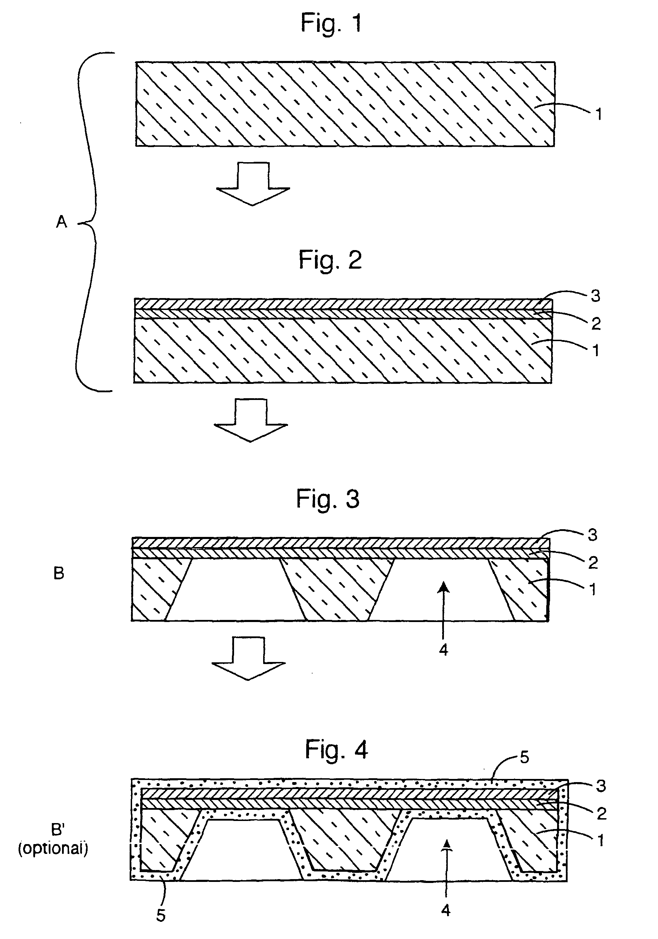

Die oben erwähnte JP 05243521 A (Abstract) zeigt eine DRAM-Speicherzelle, bei der zur Erhöhung der Speicherkapazität des Speicherkondensators unter Beibehaltung einer minimalen Chipbelegungsfläche zwei Speicherkondensatoren mit kammartig ineinander geschachtelten ersten und zweiten Elektroden in einer isolierenden Substratschicht so gebildet sind, daß sie bezüglich einer Source-Elektrode und einer Drain-Elektrode des Auswahltransistors symmetrisch sind. Gemäß Fig. 1 dieser Druckschrift stehen jeweilige Elektroden dieser übereinanderliegenden Speicherkondensatoren gemeinsam mit dem Drain-Bereich des Auswahltransistors in elektrischer Verbindung.

In DE 38 40 559 A1 wird eine Halbleiterspeichervorrichtung und ein dafür vorgesehenes Herstellungsverfahren beschrieben, bei dem von der Rückseite eines Siliziumsubstrats ein Speicherkapazitätselement gebildet wird, das mit einer Source-oder Drain-Elektrode eines als MOSFET ausgeführten Auswahltransistors in Verbindung steht. Das Speicherkapazitätelement ist als Trench-Kondensator in einem von der Rückseite des Siliziumsubstrats hergestellten Graben ausgebildet.

US-A-5,684,316 beschreibt eine Halbleiterspeichervorrichtung mit zwei oberhalb und unterhalb eines Zellentransistors ausgebildeten Speicherkondensatoren. Das darin beschriebene zur Bildung dieser Speicherkondensatoren angewendete Verfahren geht so vor, dass zuerst auf der Oberseite eines ersten Substrats ein erster Speicherkondensator gebildet wird. Die Struktur des ersten Speicherkondensators wird dann.mit einem zweiten Substrat verbunden, und die sich dadurch ergebende Struktur so gedreht, dass die bisherige Oberseite nach unten weist. Anschließend wird die Zellentransistor-Struktur, die aus zwei Transistoren besteht, aufgebaut und schließlich darüber ein zweiter Speicherkondensator hergestellt.

Es ist Aufgabe der Erfindung, ein Herstellungsverfahren für ein DRAM oder eine ferroelektrische Halbleiterspeicheranordnung so anzugeben, dass eine höhere Packungsdichte der Speicherzellen ermöglicht wird oder bei gleicher Zellfläche ein deutlich höheres Lesesignal erreicht wird.

In einer besonderen Ausgestaltung soll auch erreicht werden, dass pro Speicherzelle d. h. pro Adresse mehr Zustände als nur entweder 0 oder 1 gespeichert werden können. Die Aufgabe wird anspruchsgemäß gelöst.

Zur Lösung dieser Aufgabe schlägt die Erfindung gemäß einem wesentlichen Aspekt ein Verfahren zur Herstellung einer integrierten ferroelektrischen oder DRAM-Halbleiterspeicheranordnung auf einem Scheibensubstrat vor, bei dem pro Speicherzelle ein Auswahltransistor und zwei vom Auswahltransistor ansprechbare Speicherkondensatoren gebildet werden und bei dem die zwei Speicherkondensatoren für jede Speicherzelle jeweils von der Vorder- und Rückseite des Substrats her gebildet werden.

Das Verfahren ist **gekennzeichnet durch** folgende Schritte:
- A: Vorbereiten einer Substratscheibe und Ausbilden von Elektrodenbereichen des Auswahltransistors als CMOS-Transistor von der Scheibenvorderseite;
- B: Ätzen eines vertieften Bereichs in der Scheibenrückseite;
- C: Bildung eines ersten elektrisch leitenden Plugs innerhalb des vertieften Bereichs, so dass der erste Plug einen Elektrodenbereich des in Schritt A gebildeten Auswahltransistors kontaktiert;
- D: Bildung eines ersten Speicherkondensators in dem vertieften Bereich von der Scheibenrückseite, so dass eine zu dem Elektrodenbereich des Auswahltransistors weisende Elektrodenplatte des ersten Speicherkondensators mit dem genannten Elektrodenbereich des Auswahltransistors durch den in Schritt C gebildeten Plug in elektrisch leitende Verbindung kommt;
- E: Bildung eines zweiten elektrisch leitenden Plugs von der Vorderseite der Scheibe, so dass der zweite Plug in Kontakt mit demselben Elektrodenbereich des Auswahltransistors kommt und
- F: Bildung eines zweiten Speicherkondensators von der Vorderseite der Scheibe, so dass eine zu diesem Elektrodenbereich des Auswahltransistors weisende Elektrodenplatte des zweiten Speicherkondensators mit diesem Elektrodenbereich des Auswahltransistors durch den in Schritt E gebildeten zweiten Plug in Kontakt kommt.

Bei einer Verfahrensweise können die Schritte A bis F in dieser Reihenfolge ausgeführt werden. Eine alternative Verfahrensweise fasst die Schritte A, E und F zusammen und führt diese vor den folgenden Schritten B, C und D aus.

Ein noch anderes alternatives Verfahren bildet die Speicherkondensatoren auf den beiden Scheibenseiten parallel, d. h. etwa gleichzeitig, und führt so viele Ätzungen, Abscheidungen, Maskierungen etc. wie möglich auf beiden Scheibenseiten aus.

Durch Einbeziehen der Scheibenrückseite lässt sich eine effektivere Ausnutzung der Chipfläche einer so hergestellten integrierten Halbleiterspeicheranordnung erreichen. Durch den vorgeschlagenen Prozess werden zwei durch denselben Auswahltransistor ansprechbare Speicherkondensatoren gebildet, die dieselbe Chipfläche benötigen wie zuvor nur ein Speicherkondensator. Die kapazitätsbildende Fläche der zusammengehörigen Speicherkondensatoren und damit die gespeicherte Ladung bzw. Polarisation erhöht sich bei gleicher Chipfläche damit um das Doppelte. Dies kann entweder in Form einer erhöhten Zuverlässigkeit (höheres Bitleitungssignal) oder in einer weiteren Verringerung der Chipfläche genutzt werden.

Wenn bei einer ferroelektrischen Speicheranordnung gemäß einem Vorschlag dieser Erfindung die ferroelektrischen Filme der beiden Speicherkondensatoren unterschiedlich dick und/oder die Flächen der beiden Speicherkondensatoren unterschiedlich groß und/oder die chemischen Zusammensetzungen der Ferroelektrika der beiden Speicherkondensatoren unterschiedlich gebildet sind, können durch eine derartige Vorgehensweise zwei Bits pro Adresse, d. h. pro Auswahltransistor gespeichert werden. Wenn zum Beispiel die ferroelektrischen Filme in den beiden Speicherkondensatoren unterschiedlich dick abgeschieden werden, liegen die Koerzitivspannungen (d. h. die Spannung, bei der die Polarisation zu schalten beginnt) bei verschiedenen Werten. Je nach Größe der Auslesespannung kann nur einer oder beide Speicherkondensatoren angesprochen werden. Durch eine entsprechende Bewertungsschaltung ist es dann möglich, vier Zustände (00, 01, 10, 11) an einer Adresse zu differenzieren. Neben der unterschiedlichen Dicke der Ferroelektrika können sich, wie erwähnt, die beiden Speicherkondensatoren auch in ihrer Fläche oder in ihrem Material und somit in der gespeicherten Ladung/Polarisation unterscheiden. Die Spannungspegel beim Lesen lassen dann Rückschlüsse zu, welcher bzw. ob beide Speicherkondensatoren auf hohem Pegel oder tiefem Pegel waren.

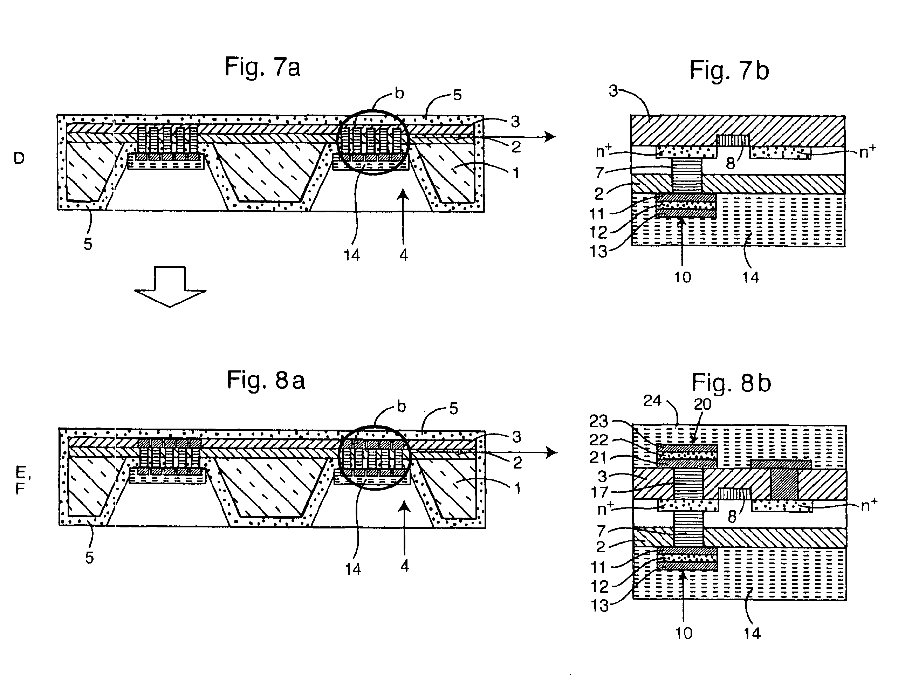

Die nachfolgende Beschreibung beschreibt anhand der Zeichnung ein Ausführungsbeispiel eines erfindungsgemäßen Herstellungsverfahrens zur Herstellung einer integrierten ferroelektrischen Speicheranordnung. Die Fig. 1 bis 8a, 8b zeigen jeweils in Form eines schematischen Querschnitts durch einen Abschnitt einer Halbleitersubstratscheibe (Wafer) einzelne Herstellungsschritte des erfindungsgemäßen Herstellungsverfahrens.

Gemäß den in Fig. 1 und Fig. 2 gezeigten Querschnittsdarstellungen wird in einem Schritt A eine zur Herstellung einer integrierten ferroelektrischen Speicheranordnung vorbereitete Halbleitersubstratscheibe 1 bereitgestellt, die entweder ein SOI-Wafer (Silicon-on-Insulator-Wafer) sein kann oder einen elektrochemischen Ätzstopp durch Ionenimplantation aufweist.
Fig. 2 zeigt, dass ein CMOS-FEOL-Prozess in einer Schicht 3 bis zu einem Zwischenoxid durchgeführt wird. Optionell kann statt des CMOS-FEOL-Prozesses auch ein kompletter Herstellungsprozess ausgeführt werden, der die Elektrodenbereiche der Auswahltransistoren und die Metallisierungsbereiche von der Vorderseite und die vorderseitigen Speicherkondensatoren von der des Wafers herstellt.

Gemäß Fig. 3 werden in einem Schritt B von der Rückseite der Scheibe 1 her durch einen anisotropen Ätzprozess vertiefte Bereiche 4 bis zu der durch einen geeigneten Ätzstopp (z. B. SOI) definierten Tiefe gebildet. Alternativ kann auch ohne Ätzstopp auf Zeit geätzt werden.

Durch einen weiteren (optionalen) Schritt B' kann gemäß Fig. 4 eine Barriereschicht 5 über dem gesamten Bereich auf der Vorder- und Rückseite der Scheibe 1 abgeschieden werden.

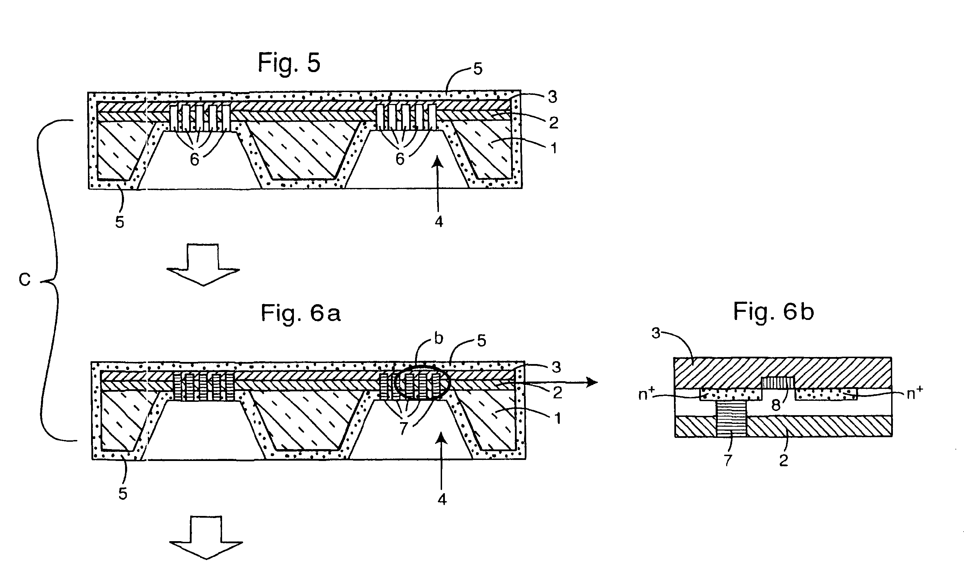

Fig. 5 zeigt, dass von der Rückseite der Scheibe 1 her Vias 6 bis zu in der Halbleiterschicht 3 liegenden Elektrodenbereichen (n⁺ in Fig. 6b) der CMOS-Auswahltransistoren geätzt werden, und Fig. 6a zeigt, dass diese Vias 6 dann mit einem geeigneten leitenden Material, zum Beispiel Polysilizium, Wolfram oder Kupfer, unter Ausbildung leitender Plug 7 ausgefüllt werden. Der in Fig. 6b dargestellte vergrößerte Bereich b von Fig. 6a zeigt, dass diese Plugs 7 einen Elektrodenbereich eines Auswahltransistors 8 in der Halbleiterschicht 3 kontaktieren.

Durch einen weiteren Schritt D, der in Fig. 7a und in vergrößerter Darstellung in Fig. 7b gezeigt ist, wird ein erster Speicherkondensator 10 in einer von der Rückseite der Scheibe 1 in den vertieften Bereichen 4 abgeschiedenen isolierenden Schicht 14 gebildet. Der erste Speicherkondensator 10 weist eine durch den Plug 7 mit dem Elektrodenbereich n⁺ des Auswahltransistors 8 verbundene erste Elektrodenplatte 11 und eine zweite Elektrodenplatte 13 mit einem zwischen den beiden Elektrodenplatten 11 und 13 liegenden Ferroelektrikum 12 auf.

Der in den Fig. 8a und 8b gezeigte Schritt E bildet von der Vorderseite der Scheibe 1 her pro Auswahltransistor 8 einen weiteren Plug 17 aus, der denselben Elektrodenbereich n⁺ des Auswahltransistors 8 kontaktiert. In einem weiteren Schritt F wird in einer auf der Vorderseite der Scheibe 1 gebildeten weiteren Isolierschicht 24 ein zweiter Speicherkondensator 20 gebildet, der aus den Elektrodenplatten 21 und 23 mit einer dazwischenliegenden ferroelektrischen Schicht 22 besteht. Die zum Auswahltransistor 8 weisende Elektrodenplatte 21 des zweiten Speicherkondensators 20 steht durch den Plug 17 mit demselben n⁺-Elektrodenbereich des Auswahltransistors 8 in Kontakt, wie die in Dickenrichtung der Scheibe gegenüberliegende Elektrodenplatte 11 des ersten Speicherkondensators 10.

Prinzipiell können die oben beschriebenen Herstellungsschritte A - F in der oben beschriebenen und in den Fig. 1 bis 8 dargestellten Reihenfolge ausgeführt werden. Ein alternatives und in der Zeichnung nicht dargestelltes Herstellungsverfahren fasst alle von der Vorderseite der Scheibe 1 her ausgeführten Prozessschritte A, E und F zusammen und diese werden vor den dann folgenden Schritten B, C und D ausgeführt, die die Elemente der ferroelektrischen Speicheranordnung von der Rückseite der Scheibe 1 her bilden.

In einem weiteren alternativen (nicht dargestellten) Herstellungsverfahren können die beiden Speicherkondensatoren 10, 20 von den beiden Scheibenseiten her parallel hergestellt werden, wobei möglichst viele Schichten und Elemente gleichzeitig auf beiden Scheibenseiten gebildet werden.

Die vergrößerte Darstellung der Fig. 8b zeigt außerdem, dass ein zweiter n⁺ Elektrodenbereich des Auswahltransistors 8 über ein weiteres Plug mit einer Metallisierungsebene, zum Beispiel einer Bitleitung, verbunden wird.

Durch das erfindungsgemäße Herstellungsverfahren lassen sich pro Auswahltransistor zwei Speicherkondensatoren jeweils in der Vorder- und Rückseite der Scheibe 1 herstellen, die durch denselben Auswahltransistor angesprochen werden. Damit erhöht sich die Kondensatorfläche und somit die gespeicherte Ladung/Polarisation bei gleicher Chipfläche um das Doppelte. Dies schlägt sich entweder in Form einer erhöhten Zuverlässigkeit (höheres Bitleitungssignal) nieder oder in einer weiteren Reduktion der Chipfläche.

Im Falle eines ferroelektrischen Speichers können durch das beschriebene Konzept zwei Bits pro Adresse (d. h. pro Auswahltransistor) gespeichert werden. Dazu werden zum Beispiel die ferroelektrischen Filme 12, 22 der beiden Speicherkondensatoren 10, 20 unterschiedlich dick abgeschieden. Dann haben deren Koerzitivspannungen (d. h. die Spannungen, bei der die Polarisation zu schalten beginnt) jeweils verschiedene Werte. Je nach Größe der Auslesespannung lässt sich einer oder beide Speicherkondensatoren 10, 20 ansprechen. Durch eine entsprechende Bewertungsschaltung ist es dann möglich, vier Zustände (00, 01, 10, 11) an einer Adresse zu differenzieren. Neben einer unterschiedliche Dicke der Ferroelektrika können sich die beiden Speicherkondensatoren auch in ihrer kapazitätsbildenden Fläche oder ihrem Material und somit in der gespeicherten Ladung/Polarisation unterscheiden. Die Spannungspegel beim Lesen lassen dann Rückschlüsse zu, welcher bzw. ob beide Speicherkondensatoren auf High oder Low waren.

Die hier einschlägigen Fachleute werden ohne Weiteres erkennen, dass die oben beschriebenen Verfahrensschritte nur die für die Erfindung wesentlichen Prozesse beschreiben und dass die in Bezug genommenen Figuren deshalb nur schematisch sind. Selbstverständlich werden in der Praxis mehr als die zwei dargestellten Vertiefungen 4 von der Substratrückseite und in jeder Vertiefung 4 mehr als nur 5 Zellen mit den jeweils zugehörigen beiden Speicherkondensatoren 10, 20 und Auswahltransistoren 8 gebildet.

### Bezugszeichenliste

- 1: Substratscheibe (Wafer)
- 2: Vergrabenes Oxid oder andere Ätzstoppschicht
- 3: Halbleiterschicht für CMOS-FEOL
- 4: vertiefte Bereiche auf der Rückseite der Scheibe 1
- 5: Barriereschicht
- 6: Vias
- 7: erste Plugs
- 8: Auswahltransistor
- 10: erstes Kondensatormodul
- 11, 12, 13: Kondensatorplatten und Dielektrikum des ersten Kondensatormoduls 10
- 14: isolierende Schicht auf der Rückseite
- 17: zweite Plugs
- 20: zweites Kondensatormodul
- 21, 22, 23: Kondensatorplatten und Dielektrikum des zweiten Kondensatormoduls 20
- 24: isolierende Schicht auf der Vorderseite der Scheibe 1
- n⁺: Elektrodenbereich des Auswahltransistors 8

## Patentansprüche

1. Verfahren zur Herstellung einer integrierten ferroelektrischen oder DRAM-Halbleiterspeicheranordnung auf einem Scheibensubstrat (1), wobei pro Speicherzelle ein Auswahltransistor (8) und zwei vom Auswahltransistor (8) ansprechbare Speicherkondensatoren (10, 20) gebildet werden, und wobei die zwei Speicherkondensatoren (10, 20) für jede Speicherzelle jeweils von der Vorder- und Rückseite des Scheibensubstrats (1) her gebildet werden,
**gekennzeichnet durch** folgende Schritte:
A Vorbereiten einer Substratscheibe (1) und Ausbilden von Elektrodenbereichen des Auswahltransistors (8) als CMOS-Transistor von der Scheibenvorderseite;
B Ätzen eines vertieften Bereichs (4) in der Scheibenrückseite;
C Bildung eines ersten elektrisch leitenden Plugs (7) innerhalb des vertieften Bereichs (4), so dass dieser erste Plug (7) einen Elektrodenbereich (n⁺) des in Schritt A gebildeten Auswahltransistors (8) kontaktiert;
D Bildung eines ersten Speicherkondensators (10) in dem vertieften Bereich (4) von der Scheibenrückseite, so dass eine zu diesem Elektrodenbereich (n⁺) des Auswahltransistors (8) weisende Elektrodenplatte (11) des ersten Speicherkondensators (10) mit dem genannten Elektrodenbereich (n⁺) des Auswahltransistors (8) **durch** den in Schritt C gebildeten Plug (7) in elektrisch leitende Verbindung kommt;
E Bildung eines zweiten elektrisch leitenden Plugs (17) von der Vorderseite der Scheibe (1), so dass der zweite, Plug (17) in Kontakt mit demselben Elektrodenbereich (n⁺) des Auswahltransistors (8) kommt und
F Bildung eines zweiten Speicherkondensators (20) von der Vorderseite der Scheibe (1), so dass eine zu diesem Elektrodenbereich (n⁺) des Auswahltransistors (8) weisende Elektrodenplatte (21) des zweiten Speicherkondensators (20) mit diesem Elektrodenbereich (n⁺) des Auswahltransistors (8) **durch** den in Schritt E gebildeten zweiten Plug (17) in elektrische Verbindung kommt.

2. Verfahren nach Anspruch 1,
**dadurch gekennzeichnet, dass**
die Schritte A - F in dieser Reihenfolge ausgeführt werden.

3. Verfahren nach Anspruch 1,
**dadurch gekennzeichnet, dass**
die Schritte A, E und F zusammengefasst und vor den Schritten B, C und D ausgeführt werden.

4. Verfahren nach einem der vorangehenden Ansprüche,
**dadurch gekennzeichnet, dass**
der erste Speicherkondensator (10) durch eine in dem vertieften Bereich (4) von der Scheibenrückseite eingebrachte und den ersten Speicherkondensator (10) bedeckende erste Isolierlage (14) elektrisch isoliert und vor Schäden durch nachfolgende Prozessschritte geschützt wird.

5. Verfahren nach einem der vorangehenden Ansprüche,
**dadurch gekennzeichnet, dass**
der zweite Speicherkondensator (20) durch eine ihn bedeckende, auf die Vorderseite der Scheibe (1) aufgebrachte, zweite Isolierlage (24) elektrisch isoliert und vor Schäden durch nachfolgende Prozessschritte geschützt wird.

6. Verfahren nach einem der vorangehenden Ansprüche,
**dadurch gekennzeichnet, dass**
im Falle einer ferroelektrischen Speicheranordnung die ferroelektrischen Filme (12, 22) der beiden Speicherkondensatoren (10, 20) unterschiedlich dick ausgebildet werden.

7. Verfahren nach einem der Ansprüche 1 bis 5,
**dadurch gekennzeichnet, dass**
im Falle einer ferroelektrischen Speicheranordnung die kapazitätsbildenden Flächen der beiden Speicherkondensatoren (10, 20) unterschiedlich groß gebildet werden.

8. Verfahren nach einem der Ansprüche 1 bis 5,
**dadurch gekennzeichnet, dass**
im Fall einer ferroelektrischen Speicheranordnung die Materialien der ferroelektrischen Filme (12, 22) der beiden Speicherkondensatoren (10, 20) mit einer jeweils unterschiedlichen chemischen Zusammensetzung gebildet werden.

## Claims

1. Method for producing an integrated ferroelectric or DRAM semiconductor memory arrangement on a wafer substrate (1), a selection transistor (8) and two storage capacitors (10, 20) that can be addressed by the selection transistor (8) being formed per memory cell, and the two storage capacitors (10, 20) for each memory cell being respectively formed from the front and rear sides of the wafer substrate (1),
**characterized by** the following steps:
A preparation of a substrate wafer (1) and formation of electrode regions of the selection transistor (8) as CMOS transistor from the front side of the wafer;
B etching of a recessed region (4) in the rear side of the wafer;
C formation of a first electrically conductive plug (7) within the recessed region (4), so that said first plug (7) makes contact with an electrode region (n⁺) of the selection transistor (8) formed in step A;
D formation of a first storage capacitor (10) in the recessed region (4) from the rear side of the wafer, so that an electrode plate (11) of the first storage capacitor (10), which electrode plate faces said electrode region (n⁺) of the selection transistor (8), is electrically conductively connected to said electrode region (n⁺) of the selection transistor (8) by the plug (7) formed in step C;
E formation of a second electrically conductive plug (17) from the front side of the wafer (1), so that the second plug (17) comes into contact with the same electrode region (n⁺) of the selection transistor (8), and
F formation of a second storage capacitor (20) from the front side of the wafer (1), so that an electrode plate (21) of the second storage capacitor (20), which electrode plate faces said electrode region (n⁺) of the selection transistor (8), is electrically connected to said electrode region (n⁺) of the selection transistor (8) by the second plug (17) formed in step E.

2. Method according to Claim 1,
**characterized in that,**
steps A-F are performed in this order.

3. Method according to Claim 1,
**characterized in that,**
steps A, E and F are combined and performed before steps B, C and D.

4. Method according to one of the preceding claims,
**characterized in that,**
the first storage capacitor (10) is electrically insulated by a first insulating layer (14), which is introduced in the recessed region (4) from the rear side of the wafer and covers the first storage capacitor (10), and is protected from damage by subsequent process steps.

5. Method according to one of the preceding claims,
**characterized in that,**
the second storage capacitor (20) is electrically insulated by a second insulating layer (24), which covers said storage capacitor and is applied to the front side of the wafer (1), and is protected from damage by subsequent process steps.

6. Method according to one of the preceding claims,
**characterized in that,**
in the case of a ferroelectric memory arrangement, the ferroelectric films (12, 22) of the two storage capacitors (10, 20) are formed with different thicknesses.

7. Method according to one of Claims 1 to 5,
**characterized in that,**
in the case of a ferroelectric memory arrangement, the capacitance-forming areas of the two storage capacitors (10, 20) are formed with different sizes.

8. Method according to one of Claims 1 to 5,
**characterized in that,**
in the case of a ferroelectric memory arrangement, the materials of the ferroelectric films (12, 22) of the two storage capacitors (10, 20) are formed with a respectively different chemical composition.

## Revendications

1. Procédé de production d'un dispositif de mémoire à semi-conducteur intégré, ferroélectrique ou DRAM sur un substrat (1) de tranche, dans lequel il est formé par cellule de mémoire un transistor (8) de sélection et deux condensateurs (10, 20) de mémoire pouvant être excités par le transistor (8) de sélection et dans lequel les deux condensateurs (10, 20) de mémoire sont formés pour chaque cellule (1) de mémoire respectivement par la face avant et la face arrière du substrat (1) de tranche,
**caractérisé par** les stades suivants :
A on prépare une tranche (1) de substrat et on forme des zones d'électrodes du transistor (8) de sélection sous la forme d'un transistor CMOS par la face avant de la tranche ;
B on ménage par attaque une zone (4) évidée dans la face arrière de la tranche ;
C on forme un premier plug (7) conducteur de l'électricité au sein de la zone (4) évidée, de sorte que ce premier plug (7) entre en contact avec une zone (n⁺) d'électrode du transistor (8) de sélection formé au stade A ;
D on forme un premier condensateur (10) de mémoire dans la zone (4) évidée par la face arrière de la tranche, de sorte qu'une plaque (11) d'électrode du premier condensateur (10) de mémoire, tournée vers cette zone (N⁺) d'électrode du transistor (8) de sélection, vienne en liaison conductrice de l'électricité avec la zone (n⁺) d'électrode mentionnée du transistor (8) de sélection par le plug (7) formé au stade C ;
E on forme un deuxième plug (17) conducteur de l'électricité par la face avant de la tranche (1), de sorte que le deuxième plug (17) vienne en contact avec la même zone (n⁺) d'électrode du transistor (8) de sélection et
F on forme un deuxième condensateur (20) de mémoire par la face avant de la tranche (1), de sorte qu'une plaque (21) d'électrode du deuxième condensateur (20) de mémoire, tournée vers cette zone (n⁺) d'électrode du transistor (8) de sélection, vienne en contact électrique avec cette zone (n⁺) d'électrode du transistor (8) de sélection par le deuxième plug (17) formé au stade E.

2. Procédé suivant la revendication 1,
**caractérisé**
**en ce que** l'on effectue les stades A à F dans cet ordre.

3. Procédé suivant la revendication 1,
**caractérisé**
**en ce que** l'on rassemble le A, E et F et on les effectue avant les stades B, C et D.

4. Procédé suivant l'une des revendications précédentes,
**caractérisé**
**en ce que** l'on isole électriquement le premier condensateur (10) de mémoire par une première couche (14) isolante, introduite dans la zone (4) évidée par la face arrière de tranche et recouvrant le premier condensateur (10) de mémoire et on le protège d'endommagements par des stades opératoires venant ensuite.

5. Procédé suivant l'une des revendications précédentes,
**caractérisé**
**en ce que** l'on isole électriquement le deuxième condensateur (20) de mémoire par une deuxième couche (24) isolante, le recouvrant et déposée sur la face avant de la tranche (1) et on le protège d'endommagements par des stades opératoires venant ensuite.

6. Procédé suivant l'une des revendications précédentes,
**caractérisé**
**en ce que**, dans le cas d'un dispositif de mémoire ferroélectrique, on donne une épaisseur différente aux films (12, 22) diélectriques des deux condensateurs (10, 20) de mémoire.

7. Procédé suivant l'une des revendications 1 à 5,
**caractérisé**
**en ce que**, dans le cas d'un dispositif de mémoire ferroélectrique, on donne des dimensions différentes aux surfaces des deux condensateurs (10, 20) de mémoire, qui forment des capacités.

8. Procédé suivant l'une des revendications 1 à 5,
**caractérisé**
**en ce que**, dans le cas d'un dispositif de mémoire ferroélectrique, on forme le matériau des films (12, 22) ferroélectriques des deux condensateurs (10, 20) de mémoire en leur donnant une composition chimique différente.
